Europäisches Patentamt

European Patent Office

Office européen des brevets

(19)

(11) EP 0 496 348 B1

(12) **EUROPEAN PATENT SPECIFICATION**

(45) Date of publication and mention
of the grant of the patent:
**02.07.1997 Bulletin 1997/27**

(51) Int Cl.6: **H01S 3/25**, H01S 3/085,
H01L 31/12, H04J 14/02,
G02B 6/12

(21) Application number: **92100927.0**

(22) Date of filing: **21.01.1992**

(54) **Multi-wavelength light detecting apparatuses having serially arranged grating directional couplers**

Lichtdetektor-Vorrichtungen für mehrere Wellenlängen mit reihenweise angeordneten Gitter-Richtkopplern

Dispositif détecteurs de lumière pour plusieurs longueurs d'ondes avec des coupleurs directionels à réseaux arrangés en série

(84) Designated Contracting States:
**DE FR GB NL**

(30) Priority: **22.01.1991 JP 21536/91**
**23.01.1991 JP 22925/91**

(43) Date of publication of application:
**29.07.1992 Bulletin 1992/31**

(73) Proprietor: **CANON KABUSHIKI KAISHA**
**Tokyo 146 (JP)**

(72) Inventors:
• **Sakata, Hajime, c/o Canon Kabushiki Kaisha**
**Tokyo (JP)**
• **Takeuchi, Shinsuke,**
**c/o Canon Kabushiki Kaisha**
**Tokyo (JP)**

(74) Representative: **Pellmann, Hans-Bernd, Dipl.-Ing.**
**Patentanwaltsbüro**
**Tiedtke-Bühling-Kinne & Partner**
**Bavariaring 4**
**80336 München (DE)**

(56) References cited:
**EP-A- 0 345 923** **EP-A- 0 386 797**

• **PATENT ABSTRACTS OF JAPAN vol. 14, no. 138 (P-1022)15 March 1990;& JP-A-2004209**
• **PATENT ABSTRACTS OF JAPAN vol. 12, no. 12 (P-655)14 January 1988;& JP-A-62170907**
• **PATENT ABSTRACTS OF JAPAN vol. 12, no. 95 (P-681)29 March 1988;& JP-A-62229105**
• **PATENT ABSTRACTS OF JAPAN vol. 14, no. 230 (P-1048)16 May 1990;& JP-A-2056508**
• **PATENT ABSTRACTS OF JAPAN vol. 14, no. 278 (E-941)15 June 1990;& JP-A-2087581**
• **Patent Abstracts of Japan, vol.13, no.180 (P-846) 27.04.1989 & JP-A-1011207**
• **Journal of Lightwave Technology, 8(1990)5, pp. 748-755**

# Description

## BACKGROUND OF THE INVENTION

### Field of the Invention

The present invention relates to multi-wavelength light detecting apparatuses having serially arranged grating directional couplers to be utilized in wavelength or frequency division multiplexing optical communication systems, wavelength or frequency division multiplexing optical interconnections, optical operations, recordings and measurements utilizing light in a certain wavelength range and the like. Such light detecting apparatuses include a multi-wavelength light emitting apparatus having a plurality of serially arranged semiconductor lasers and an integrated structure for emitting lights of different wavelengths from a common emission end surface, a demultiplexing light detecting apparatus having a plurality of serially arranged photodetector and so forth.

### Related Background Art

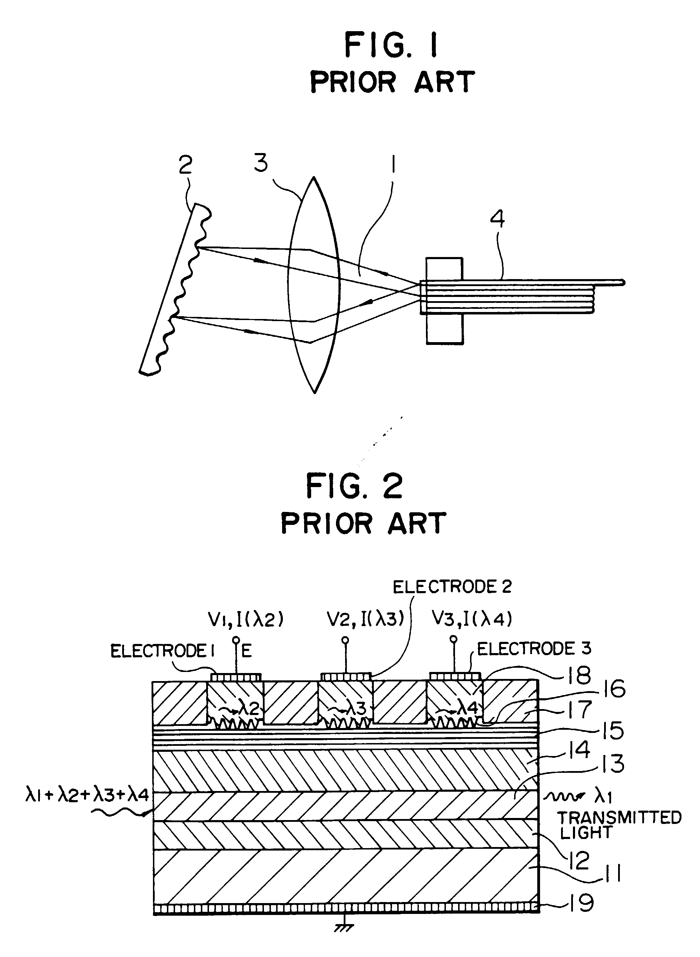

In general, in optical fiber communication systems and the like, so-called a demultiplexing photodetector is important for separating and detecting wavelength-multiplexed light signals per each wavelength. As a prior art demultiplexing light detecting apparatus or photodetector, such as illustrated in Fig. 1, for example, exists (see Electronics Information Communication Society Autumn Grand Meeting Informal Paper B-469 (1989)). In this apparatus, an input light 1 having a plurality of wavelength components is reflected and diffracted by a Fourier diffraction grating 2, and is again imaged by a collimating lens 3 for the separation of the wavelength components. An optical fiber array 4 is disposed at the image position of the reflection-diffracted light, and each wavelength component is detected.

This apparatus, however, has the drawback that an entire apparatus inevitably becomes large for the apparatus must spatially expand the light. Furthermore, the optical path length of the light beam 1 needs to be prolonged in order to improve the wavelength resolution and reduce the cross talk, which also leads to the apparatus of a large size.

To solve these drawbacks, such an apparatus as is disclosed in Fig. 2 has been proposed (see Japanese Patent Laid-Open No. 2-4209). In this apparatus, on a substrate 11, there are provided an n-AlGaAs first reflection layer 12, an n-AlGaAs waveguide layer 13, an n-AlGaAs second reflection layer 14, an undoped GaAs/AlGaAs superlattice light absorption layer 15, diffraction gratings 16, an n-AlGaAs third reflection layer 17, a p-AlGaAs third reflection layer 18, three electrodes 1, 2 and 3 formed on the p-AlGaAs third reflection layer 18 and a common electrode 19 formed on the bottom of the substrate 11. As shown in Fig. 2, a pin photodiode is constructed by the p-AlGaAs third reflection layer 18, the undoped GaAs/AlGaAs superlattice light absorption layer 15, the n-AlGaAs second reflection layer 14, the electrodes 1, 2 and 3, the electrode 19 and so forth, and the grating 16 is formed therein. In this structure, out of an input light of wavelengths $(\lambda_1, +\lambda_2+\lambda_3+\lambda_4)$ introduced into the n-AlGaAs waveguide layer 13, components of predetermined wavelengths (in this case, from the light input side, the components of $\lambda_2$, $\lambda_3$ and $\lambda_4$ are transferred in this order by controlling respective voltages $V_1$, $V_2$ and $V_3$) are transferred into the light absorption layer 17 by the respective gratings 16 to perform a wavelength selection function. Thus, the apparatus has been made compact in size, and the integration is facilitated.

In this apparatus, however, since the selected wavelength is tuned by the control of the voltage applied to each of the electrodes 1, 2, and 3, different voltages are necessarily applied to the respective photodetectors composed of the pin structures under the electrodes 1, 2 and 3, and hence an equal voltage cannot be applied thereto. Therefore, the problem occurs that the detected current $I(\lambda_2)$, $I(\lambda_3)$ and $I(\lambda_4)$ and response speed (i.e., sensitivity speed) differ among the respective photodetectors In general, an optimal use voltage is given according to the structure of each photodetector.

On the other hand, a multi-wavelength light emitting apparatus or semiconductor laser is also a critical device for the wavelength division multiplexing optical transmission systems, optical interconnection systems and the like. In these optical transmission and interconnection systems and the like, it is needed to multiplex and transmit output lights from the multi-wavelength light emitting apparatus or a plurality of laser lights of different wavelengths.

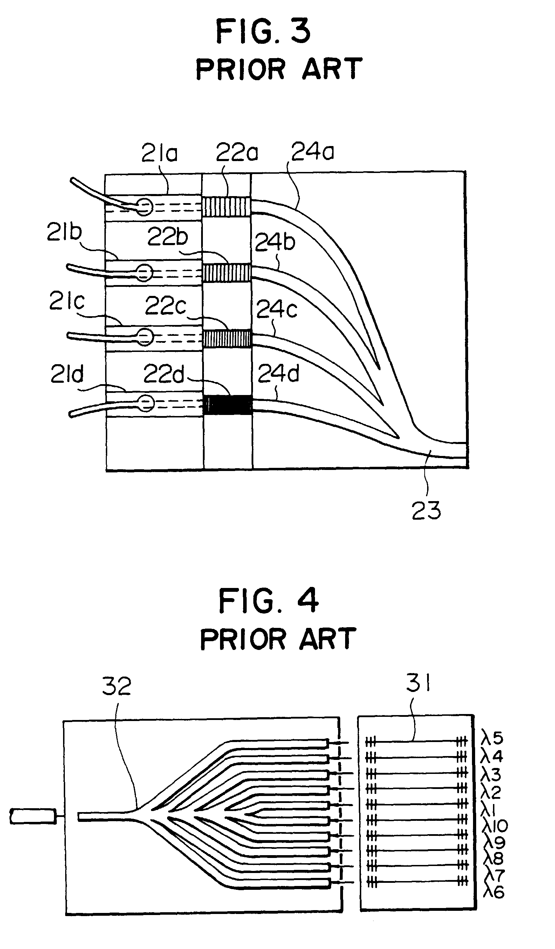

Conventionally, this kind of multi-wavelength light emitting apparatus or semiconductor laser is fabricated by parallelly integrating semiconductor lasers having outputs of different wavelengths and arranging a structure for combining the output light signals. For example, there has been proposed a structure in which output lights from parallelly integrated semiconductor lasers are combined by a Y-type combining device and an output of multiplexed laser lights is emitted from a single outlet, as shown in Fig. 3 (see Japanese Patent Laid-Open No. 55-163888) and in Fig. 4 (see Japanese Patent Laid-Open No. 58-175884). In Fig. 3, lights radiated from distributed Bragg reflection (DBR) type semiconductor lasers 21a~21d provided with gratings 22a~22d are guided into a common light waveguide 23 after they propagate through respective light waveguides 24a~24d. The thus combined light is emitted from a single outlet. In Fig. 4, lights oscillated by plural lasers 31 (wavelengths $\lambda_1$-$\lambda_{10}$) are guided into a common light waveguide 32 after they propagate through respective light waveguides, and the thus combined light is emitted from a single outlet.

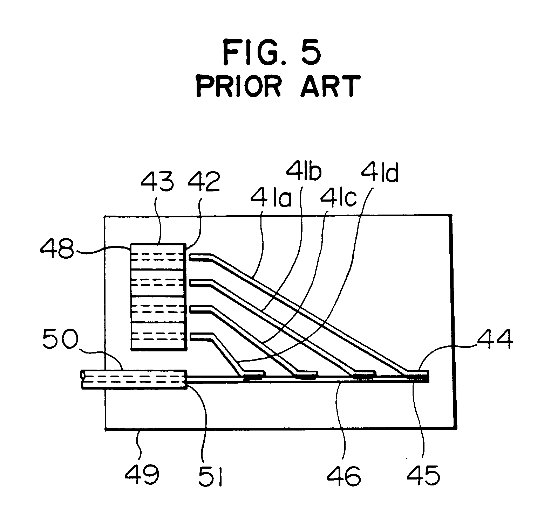

Furthermore, in another prior art apparatus illustrated in Fig. 5 (see Japanese Patent Laid-Open No.

62-229105), respective light waveguides 41a~41d are extended from respective light emission end surfaces 42 of plural semiconductor lasers 43 to wavelength selection type directional couplers 44 provided with respective gratings or periodic structures 45. The radiated lights are thus guided into a common light waveguide 46. Antireflection coats are formed on the respective light emission end surfaces 42, and no antireflection coats are formed on the other light emission end surfaces 48. The light waveguides 41a~41d are formed on a light waveguide substrate 49. There are further provided a light output fiber 50, and a high-reflection surface 51 is formed on the end surface of the fiber 50.

In such structures in which the semiconductor lasers are parallelly integrated arid the combining portion for the output light is constructed by the curved light waveguides, however, the problem occurs that the size of the entire multi-wavelength semiconductor laser becomes extremely large. For example, assuming that the distance between the parallel semiconductor lasers is 100 μm, at least 1 mm is needed in a lateral direction (direction of parallel arrangement) when ten lasers are integrated. And a coupler length of 30 mm is needed to combine two output lights which are remote from each other by a maximum of 1 mm, when a combining angle is assumed to be 2 degrees.

Thus, only a multi-wavelength semiconductor laser of a quite large size could be obtained according to the prior art struture. Furthermore, in the prior art combining device/multiplexing device, since the propagation length is long, magnitudes of the propagation loss and radiation loss at the curved portion are not negligible and the output light intensity of the laser light is reduced.

SUMMARY OF THE INVENTION

An object of the present invention is to provide multi-wavelength light detecting apparatuses having serially arranged grating directional couplers which are small in size and have a good performance.

Another object of the present invention is to provide a demultiplexing light detecting apparatus having a small size, an integrated structure and a good performance.

The invention will be more readily understood in connection with the following detailed description of the preferred embodiment in conjunction with the drawings.

BRIEF DESCRIPTION OF THE DRAWINGS

Fig. 1 is a schematic view showing a first prior art example of a demultiplexing photodetector.

Fig. 2 is a sectional view showing a second prior art example of a demultiplexing photodetector.

Fig. 3 is a schematic view showing a first prior art example of a multi-wavelength semiconductor laser.

Fig. 4 is a schematic view showing a second prior art example of a multi-wavelength semiconductor laser.

Fig. 5 is a schematic view showing a third prior art example of a multi-wavelength semiconductor laser.

Fig. 6 is a sectional view illustrating a first embodiment of the present invention directed to a demultiplexing light detecting apparatus.

Fig. 7 is a plan view of the first embodiment of the present invention.

Fig. 8 is a graph representing a spectrum response of the first embodiment of the present invention.

Fig. 9 is a partly broken perspective view of a second embodiment of the present invention directed to a demultiplexing light detecting apparatus.

Fig. 10 is a partly broken perspective view of a first example useful for the understanding of the present invention, which example is directed to a multi-wavelength light emitting apparatus.

Fig. 11 is a sectional view of a second example useful for the understanding of the present invention, which example is directed to a multi-wavelength light emitting apparatus.

DESCRIPTION OF THE PREFERRED EMBODIMENT

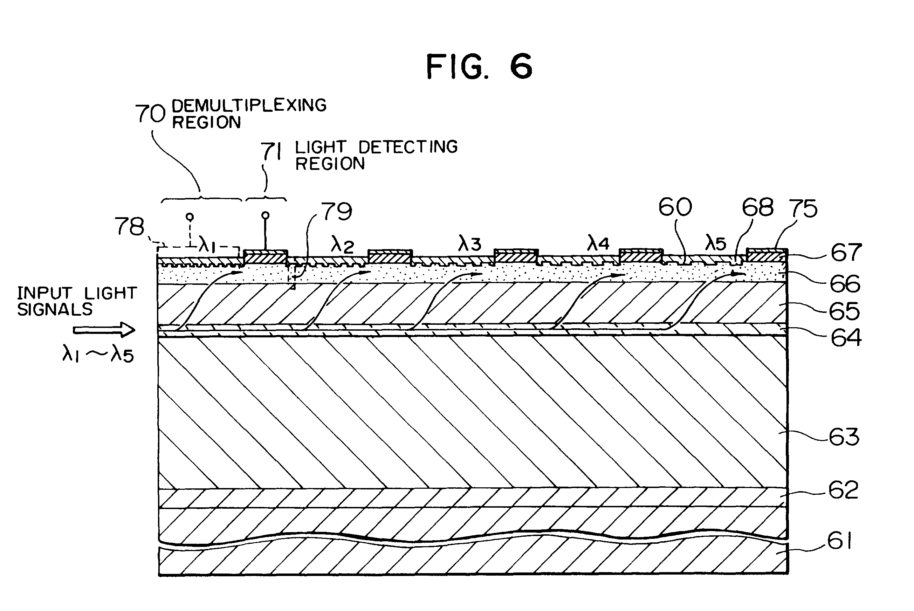

Fig. 6 shows a first embodiment of the present invention directed to a demultiplexing light detecting apparatus. In this demultiplexing light detecting apparatus, there are provided two waveguides 64 and 66 layered on a semiconductor substrate 61, and one of the waveguides 64 and 66 (in this case, the waveguide 66) has a grating 60 formed thereon. The two waveguides 64 and 66 respectively have different thicknesses and/or refractive indexes to form a so-called asymmetic directional coupler, and a mode coupling is caused between the waveguides 64 and 66 by the grating 60 solely at a wavelength at which the compensation of a propagation constant occurs. That is, the coupling from the lower waveguide 64 to the upper waveguide 66 occurs to cause a light transfer to the upper waveguide 66 due to the grating 60 at the wavelength at which the coupling between the waveguides 64 and 66 is established, out of lights of wavelengths $\lambda_1$-$\lambda_5$ incident on and coupled to the lower waveguide 64.

A wavelength resolution is improved by a combination of the asymmetric directional coupler and the grating 60 formed in such a demultiplexing region 70, compared with a case where a mode dispersion is utilized between waveguides which form a simple directional coupler. Therefore, the multiplicity or the number of channels of signals in the wavelength division multiplexing system can be increased if the instant structure is used.

The light coupled to the upper waveguide 66 is absorbed by a light detecting layer 67 formed downstream of the grating 60 (i.e., in a light detecting region 71), and a signal detection is performed. Signal lights of the other wavelengths further advance along the lower waveguide 64 without being absorbed by the light detecting layer 67, and proceed to a next demultiplexing region 70. Thus, only light signals of predetermined wavelengths are coupled to the upper waveguide 66 and detected.

In this embodiment, a plurality of demultiplexing photodetectors each composed of the demultiplexing region 70 and the light detecting region 71 are serially connected along a light propagating direction in accordance with the wavelength multiplicity of input light signals. Pitches of gratings 60 in the respective demultiplexing regions 70 are different from one another depending on the wavelengths to be selected in the respective regions 70. Since the wavelength at which the propagation constant is compensated for differs according to the grating pitch, light signals of different wavelength components can be simultaneously detected in the first embodiment.

The first embodiment is fabricated in the following manner. In Fig. 6, on the semi-insulating GaAs substrate 61, an undoped ($\phi$-) GaAs buffer layer 62 of 0.5$\mu$m thickness, a $\phi$-Al$_{0.5}$Ga$_{0.5}$As cladding layer G3 of 1.5 $\mu$m thickness, the lower waveguide 64 having a multiple quantum well (MQW) structure composed of plural periods of $\phi$-GaAs (thickness: 3nm (30Å)) / $\phi$-Al$_{0.5}$Ga$_{0.5}$As (thickness:8nm (80Å)) and a total thickness of 0.08 $\mu$m, a $\phi$-Al$_{0.5}$Ga$_{0.5}$As cladding layer 65 of 0.8 $\mu$m thickness, the upper waveguide 66 having a multiple quantum well (MQW) structure composed of plural periods of $\phi$-GaAs (thickness : 3nm (30Å)) / $\phi$-Al$_{0.4}$Ga$_{0.6}$As (thickness: 6nm(60 Å)) and a total thickness of 0.45 $\mu$m, arid the n-GaAs light detecting layer 67 of 0.2 $\mu$m thickness (dopant concentration: n=3 $\times$ 10$^{17}$ cm$^{-3}$) are grown in this order by a molecular beam epitaxy (MBE) method.

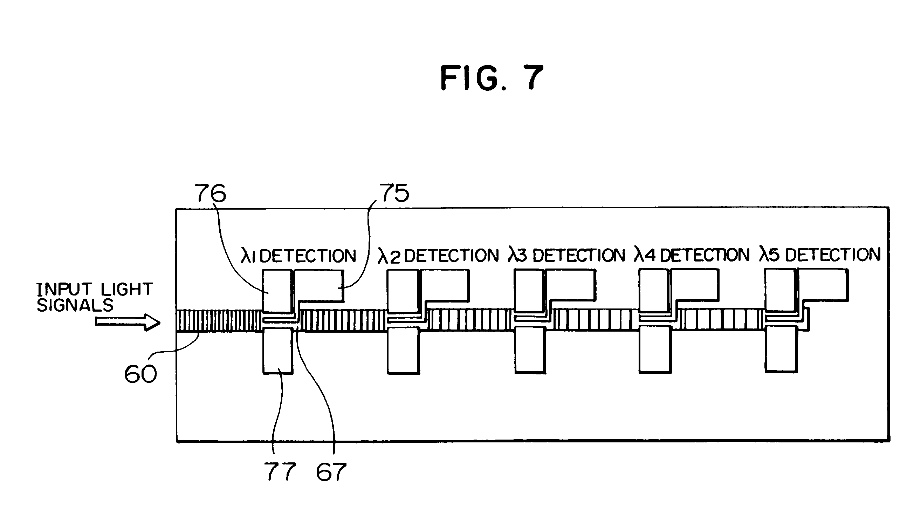

A patterning is conducted on the n-GaAs light detecting layer 67 by resist-patterning and dry-etching to form the MES-FET type light detecting region 71. Resist-patterning and reactive ion beam etching (RIBE) are then repeated to form ridge or rib type waveguides provided with the gratings 60 respectively having different pitches upstream of the respective light detecting regions 71 as shown in Figs. 6 and 7. Next, after a cover layer 68 of SiO$_2$ for the waveguide 66 is layered. Au/Cr source and drain electrodes 76 and 77 are formed on the light detecting region 71 in such a manner to surround the waveguide 66 as shown in Fig. 7. Heat treatment is performed to obtain ohmic contants. Further, after an Al gate electrode 75 is formed between the source electrode 76 and the drain electrode 77, pick-up electrodes are respectively fabricated for gate, source and drain electrodes 75, 76 and 77. Thus, the MES-FET type light detecting region 71 is fabricated.

In this embodiment, five demultiplexing photodetectors are serially arranged, and grating pitches in the respective demultiplexing regions 70 are respectively 9$\mu$m, 9.25 $\mu$m, 9.5$\mu$m, 9.75 $\mu$m and 10$\mu$m from the light signal input side. The depth of the respective gratings 60 is 0.1 $\mu$m, and the length thereof is 500$\mu$m.

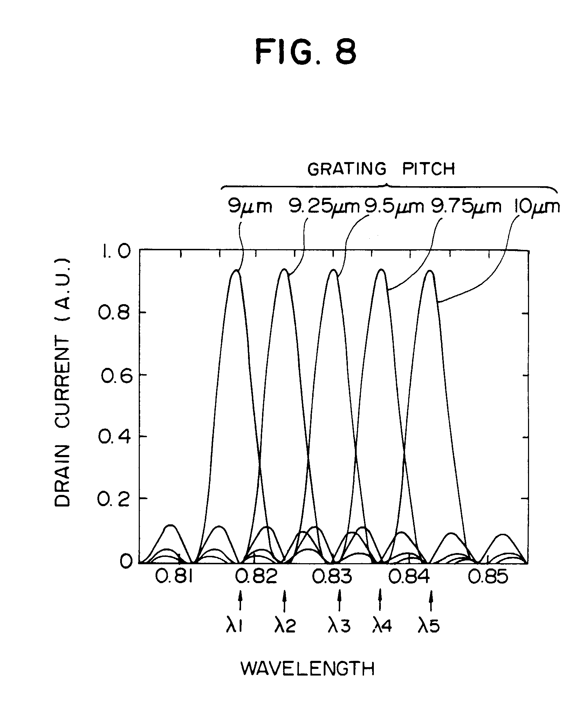

In the first embodiment having the above structure, when a voltage of -3 V is applied to the respective gate electrodes 75, response characteristics as shown in Fig. 8 are obtained for input wavelengths from 0.805 $\mu$m to 0.855 $\mu$m. Numerals indicated at a top portion of Fig. 8 are respectively grating pitches, and the response characteristics of the photodetectors having these pitches in the respective demultiplexing regions 70 are illustrated. From Fig. 8, it is seen that a simultaneous detection of light signals having wavelengths $\lambda_1$=0.817 $\mu$m, $\lambda_2$=0.824 $\mu$m, $\lambda_3$=0.83$\mu$m, $\lambda_4$=0.836 $\mu$m and $\lambda_5$=0.842 $\mu$m has been attained. The entire length of the device of the first embodiment amounts to 2.6 mm because five units respectively composed of the grating region 70 having the length of 500$\mu$m and the light detecting region 71 having the length of 20$\mu$m are serially arranged in the light propagating direction. To sum up, the simultaneous light detection of five wavelengths is possible in such a device whose light propagating entire length is merely 2.5 mm.

In the first embodiment, another electrode 78 may be formed on the demultiplexing region 70 as shown by dotted lines in Fig. 6 to change the wavelength to be demultiplexed at this region 70 by controlling a voltage applied thereto. This change is based on a change in an equivalent refractive index of the upper waveguide 66 due to plasma effect, quantum confined Stark effect (QCSE) or other effect.

Since a shorter wavelength is more likely to be absorbed than a longer wavelength, it is preferable to dispose regions for demultiplexing and detecting lights of shorter wavelengths at the light input side as far as possible. The first embodiment actually adopts such structure.

Furthermore, in order to more completely prevent light of a wavelength demultiplexed at an upstream region from invading to a next light detecting region 71, a groove 79 having an appropriate depth extending in a direction of layered layers or a light absorbing region may be formed between adjacent demultiplexing and light detecting regions 70 and 71, as shown by dotted lines in Fig. 1. Moreover, a boundary surface between the adjacent regions may be slantly formed to the light propagating direction to reflect light from an upstream upper waveguide 66 in a different direction from the light propagating direction.

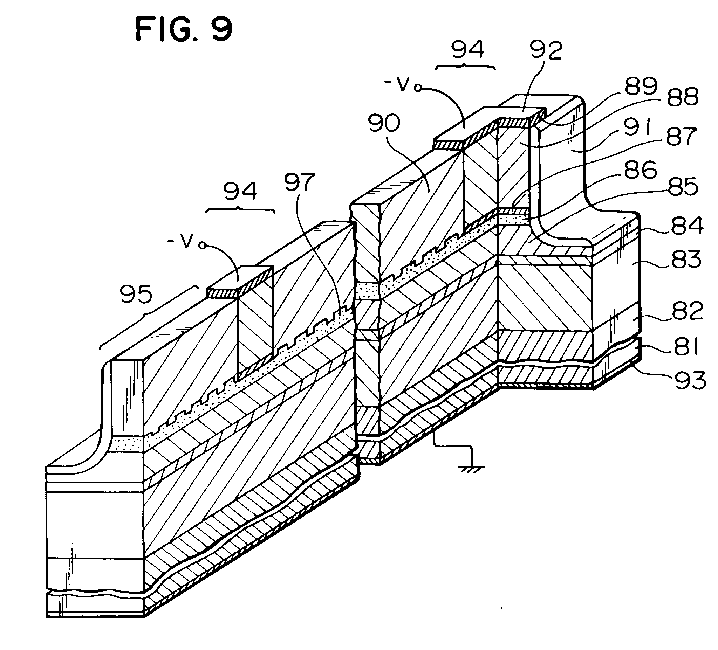

In the first embodiment, the MES-FET photodetector is used, but that of other type may be used. In a second embodiment shown in Fig. 9, a pin type photodiode is used as a photodetector.

The second embodiment shown in Fig. 9 is fabricated in the following manner. In Fig. 9, on an n$^+$-GaAs substrate 81, an n-GaAs buffer layer 82 of 0.5 $\mu$m thickness (dopant concentration: n=2$\times$10$^{18}$ cm$^{-3}$). n-Al$_{0.5}$Ga$_{0.5}$As cladding layer 83 of 1.5 $\mu$m thickness (dopant concentration: n=1$\times$10$^{-17}$ cm$^{-3}$), a lower waveguide 84 having a n- type multiple quantum well (n-MQW) structure composed of plural periods of GaAs (thickness: 3nm (30Å) /Al$_{0.5}$Ga$_{0.5}$As (thickness: 8nm (80 Å)) and a total thickness of 0.08 $\mu$m (dopant concentration: n=1$\times$10$^{17}$

$cm^{-3}$), an intermediate $n-Al_{0.5}Ga_{0.5}As$ cladding layer 85 of 0.8 μm thickness (dopant concentration: $n=1\times10^{17}$ $cm^{-3}$). an $n-Al_{0.2}Ga_{0.8}As$ upper waveguide 86 of 0.25 μm thickness (dopant concentration: $n=1\times10^{17}$ $cm^{-3}$), a n-GaAs light detecting layer 87 of 0.05 μm thickness (dopant concentration: $n=5\times10^{15}$ $cm^{-3}$), a p-$Al_{0.5}Ga_{0.5}As$ cladding layer 88 of 1.5 μm thickness (dopant concentration: $p=1\times10^{18}$ $cm^{-3}$) and a p-GaAs contact layer 89 of 0.5 μm thickness (dopant concentration: $p=1\times10^{18}$ $cm^{-3}$) are grown in this order by the molecular beam epitaxy (MBE) method.

Next, only a light detecting region 94 is covered by photoresist, and the p-GaAs contact layer 89 is removed by an etchant of ammonia : hydrogen peroxide solution (1 : 200). Then, the $p-Al_{0.5}Ga_{0.5}As$ cladding layer 88 is removed by an etchant of hydrochloric acid : hydrogen peroxide solution (1 : 200), and thereafter the n-GaAs light detecting layer 87 is removed by an etchant of ammonia : hydrogen peroxide solution (1 : 200).

On the $n-Al_{0.2}Ga_{0.8}As$ upper waveguide 86 exposed by the above removal, a grating 97 is formed by the RIBE method, and a $\phi-Al_{0.5}Ga_{0.5}As$ layer 90 is selectively formed by a metal organic chemical vapor deposition (MOCVD) method. The depth of the grating 97 is 0.1 μm, and its pitch is set from 6 μm to 7.5μm with an interval of 0.15 μm. Therefore, eleven demultiplexing photodetector units are serially arranged as a whole. The length of a grating region 95 is 400μm, and that of the light detecting region 94 is 50 μm. Thus, the entire length of this device is about 5 mm.

Furthermore, in order to achieve a confinement in a lateral direction, a ridge structure of a width of 3μm extending in the light propagating direction (i.e., a direction perpendicular to the grating 97) is formed by the RIBE method (i.e., the ridge structure is formed by etching to the intermediate cladding layer 85), and an insulating layer 91 of $Si_3N_4$ is grown on the ridge side surface except for the contact layer 89. On the contact layer 89 in the light detecting region 94, an AuCr/Au electrode 92 is then deposited, and an AuGe/Au electrode 93 is deposited on the bottom surface of the substrate 81 after this bottom surface is lapped. Finally, ohmic contacts of the electrodes 92 and 93 are achieved by a high-temperature treatment, and a wafer is chipped.

In the second embodiment having the above structure, a voltage of -5 V is applied to the respective light detecting regions 94 (pin photodiodes), and a light signal of 20 Mbps is input into the lower waveguide 84. The light signal is wavelength-division multiplexed, and has eleven channels with an interval of 3 nm from $\lambda=820$ nm to $\lambda=850$ nm. In the second embodiment, respective wavelength components are selected in the demultiplexing regions 95 having respective gratings 97, and the selected components are coupled to the upper waveguide 86 to be absorbed and detected in the respective light detecting layers 87. The eleven-channel light signals can be independently detected, and a cross talk between the wavelengths is less than -20 dB. A minimum detectable light power level is -40 dBm at the input stage. Also in the second embodiment, modifications or changes similar to those of the first embodiment are possible.

In the demultiplexing light detecting apparatus according to the present invention, a plurality of units of directional coupler type demultiplexing regions respectively having gratings of different pitches and light detecting regions are serially arranged in the light propagating direction such that the wavelength-division multiplexed light signals and the like may be simultaneously detected.

The directional coupler type demultiplexing device in which the optical coupling between the waveguides are performed with the aid of the grating is used in each demultiplexing region, and hence the wavelength resolution is enhanced. As a result, the wavelength multiplicity can be made large, i.e., the number of signal channels can be increased, and therefore, a high density optical communication can be attained. Furthermore, a voltage is applied in the light detecting region independently from the demultiplexing region, and hence the light detecting performance of each unit can be unified. Moreover, the demultiplexing light detecting apparatus of this invention only needs to have a light propagation length of several mm for simultaneously detecting signals of wavelengths from several to several tens, and this photodetector is thus compact in size and is suitable to the integration with other devices.

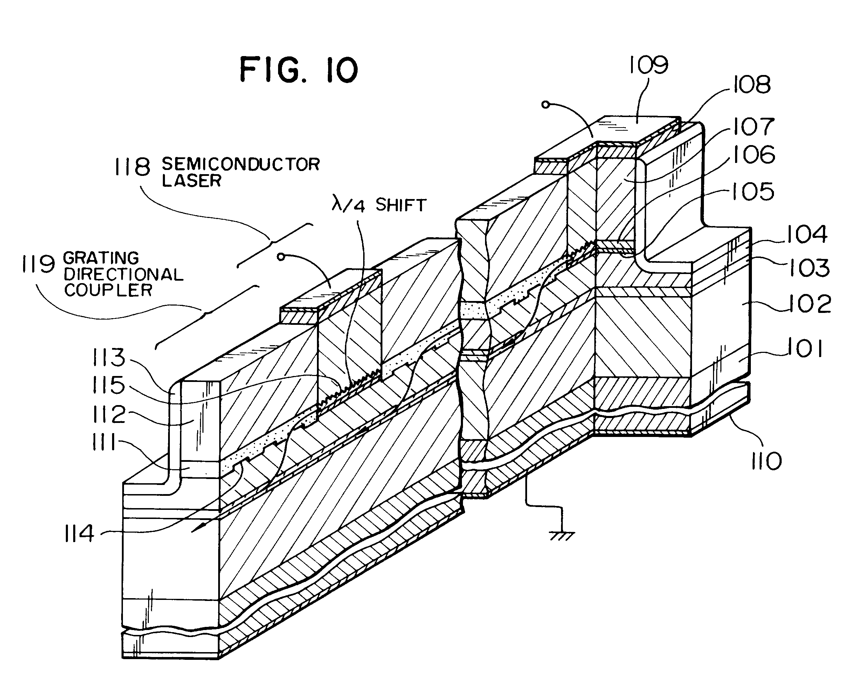

Fig. 10 shows a basic structure of a first example useful for the understanding of the present invention, which example is directed to a multi-wavelength light emitting apparatus. In this multi-wavelength light emitting apparatus, there are provided a plurality of units of semiconductor lasers having different oscillation wavelengths and directional grating couplers for causing an optical coupling between waveguides in accordance with respective oscillation wavelengths serially arranged in the light propagating direction The semiconductor is preferably a distributed feedback (DFB) or distributed Bragg reflection (DBR) type laser which is suitable to the integration, but other types of lasers may he used. In this embodiment, a semiconductor laser 118 is the DFB type, and has a grating of a pitch $\Lambda_{LD,i}$ in accordance with an oscillation wavelength $\lambda_i$. The pitch $\Lambda_{LD,i}$ is represented by:

$$\Lambda_{LD,i}=m\cdot \lambda_i/2n_{eff} \qquad (m=1, 2, 3, \cdots) \qquad (1)$$

where $n_{eff}$ is the effective refractive index of an oscillation mode. This relation holds true in a case of the DBR type.

In this example, there is provided a common waveguide 103 at a certain distance from an active layer 105 of the semiconductor laser 118. In a grating directional coupler 119, an upper waveguide 111 is formed in accord with the active layer 105 of the semiconductor laser 118, and the common waveguide 103 is also formed in accord with the waveguide 103 in the semiconductor laser 118. A grating 114 for wavelength selection coupling is formed in a coupling region between the upper waveguide 111 and the common waveguide 103.

The two waveguides of the grating directional coupler 119, namely, the upper waveguide 111 and the common waveguide 103 have different thicknesses and/or refractive indexes to form a so-called asymmetric directional coupler, and a mode coupling is caused between the waveguides 111 and 103 by the grating 114 solely at a wavelength at which the compensation of a propagation constant occurs. That is, the coupling from the upper waveguide 111 to the common waveguide 103 occurs to cause a light transfer to the common waveguide 103 due to the grating 114 at a wavelength at which the mode matching is estahlished, out of lights radiated by the semiconductor lasers 118 and propagating along the upper waveguide 111. Here, a pitch $\Lambda_{g,i}$ of the grating 114 is represented by:

$$\Lambda_{g,i} = \lambda_i / |n_{up,i} - n_{com,i}| \qquad (2)$$

where $\lambda_i$ is the oscillation wavelength of the semiconductor laser 118, $n_{up,i}$ is the effective refractive index of a mode propagating through the upper waveguide 111 and $n_{com,i}$ is the effective refractive index of a mode propagating through the common waveguide 103. The minus sign (-) at the right side indicates a forward direction coupling.

Thus, in the coupling due to the directional coupler through the grating 114, a strong wavelength selection is caused near the Bragg condition represented by the equation (2). Therefore, a light transfer between the waveguides 111 and 103 occurs solely at a desired laser oscillation wavelength. Conversely speaking, the pitch $\Lambda_{g,i}$ of the grating 114 in the grating directional coupler 119 is set in accordance with the oscillation wavelength of the corresponding semiconductor laser 118 so as to cause such light transfer.

In this example, there are provided a plurality of units of the semiconductor lasers 118 and the grating directional couplers 119 formed in accordance with the respective oscillation wavelengths of corresponding semiconductor lasers 118, and these units are serially arranged in the light propagating direction, corresponding to different wavelengths of the wavelength division multiplexing system. Namely, lights radiated from the respective semiconductor lasers 118 are guided to the common waveguide 103 by the respective grating couplers 119 and propagated through the common waveguide 103. Those propagating lights will not be coupled to downstream semiconductor lasers 118 and grating directional couplers 119 when propagating therethrough. Thus, those lights are emitted from a common emission end (in Fig. 10, the end surface at the left hand side.).

As explained above, in this embodiment, the grating pitch of the semiconductor laser 118 is set by the equation (1) in accordance with each radiation wavelength, and the grating pitch of the grating directional coupler 119 is set by the equation (2), so that the device is capable of being independently driven per each wavelength. As a result, wavelength division multiplexed light signals can be emitted from the common emission end.

The first example is fabricated in the following manner. In Fig. 10, on an $n^+$-GaAs substrate 101, an n-GaAs buffer layer (not shown) of 0.5 μm thickness (dopant concentration: $n=2\times10^{18}$ cm$^{-3}$), an n-Al$_{0.5}$Ga$_{0.5}$As cladding layer 102 of 1.5 μm thickness (dopant concentration: $n=1\times10^{17}$ cm$^{-3}$), the n-Al$_{0.3}$Ga$_{0.7}$As common waveguide 103 of 0.08 μm thickness (dopant concentration: $n=1 \times 10^{17}$ cm$^{-3}$), an intermediate n-Al$_{0.5}$Ga$_{0.5}$As cladding layer 104 of 0.8 μm thickness (dopant concentration: $n=1 \times 10^{17}$ cm$^{-3}$), the undoped (φ-) Al$_{0.07}$Ga$_{0.93}$As active layer 105 of 0.07 μm thickness and a p-Al$_{0.2}$Ga$_{0.8}$As guide layer 106 of 0.2 μm thickness are grown in this order by the MOCVD method.

Next, after a photoresist is coated, a two-beam interference pattern of a He-Cd laser having a pitch changed per the oscillation wavelength is exposed in a region in which each semiconductor laser 118 is to be formed and the development is conducted therein. The p-Al$_{0.2}$Ga$_{0.8}$As guide layer 106 is then etched by the RIBE, and a fine grating pattern 115 as shown in Fig. 10 is obtained after removal of the photoresist. The grating pattern 115 has so-called a λ/4 shift structure in its central portion in order to overcome the instability of the oscillation mode. The λ/4 shift structure can be easily obtained by such a method in which negative and povitive photoresists are alternately coated (for example, see Japanese Patent Laid-Open No. 62-262004).

Next, after masking a portion to be the grating directional coupler 119 with SiO$_2$, a p-Al$_{0.5}$Ga$_{0.5}$As cladding layer 107 (dopant concentration: $p=1 \times 10^{18}$ cm$^{-3}$) and a p$^+$-GaAs contact layer 108 (dopant concentration: $p^+=2\times10^{18}$ cm$^{-3}$) are grown on the fine grating 115 by the MOCVD method. The DFB type semiconductor laser 118 is fabricated by the above process.

On the other hand, the grating directional coupler 119 is produced as follows. After the SiO$_2$ mask on its region is removed, a SiO$_2$ mask is in turn formed on the semiconductor laser 118. The p-Al$_{0.2}$Ga$_{0.8}$As guide layer 106 is removed by a mixture etchant of sulfuric acid : hydrogen peroxide solution : water, and the φ-Al$_{0.07}$Ga$_{0.93}$As active layer 105 is removed by a mixture etchant of ammonia : hydrogen peroxide solution. Then. after a photoresist is coated, this portion is exposed through a photomask in which the grating pitch is set in accordance with the position of the grating directional coupler 119 and the coupling wavelength, and is developed. The portion is etched by the RIBE, and the grating 114 as shown in Fig. 10 is obtained after the photomask is removed. In this embodiment, since the pitch of the grating 114 is relatively rough, the grating 114 can be obtained by such process.

On the grating 114, the φ-MQW upper waveguide 111 (well : GaAs of 3 nm (30Å) thickness, and barrier : $Al_{0.4}Ga_{0.6}As$ of 8 nm (80 Å) thickness) of 0.5 μm thickness and a φ-$Al_{0.5}Ga_{0.5}As$ cladding layer 112 of 1.5 μm thickness are grown by the MOCVD method to fabricate the grating directional coupler 119.

Furthermore, after the $SiO_2$ mask on the semiconductor laser 118 is removed, a ridge structure of 3 μm width extending in a direction perpendicular to the gratings 114 and 115 (light propagating direction) as shown in Fig. 10 is formed by a photoresist and the RIBE method, and an $Si_3N_4$ layer 113 is embedded at both sides of the ridge. On the p⁺-contact layer 108 of the semiconductor laser 118, an Au-Cr/Au electrode 109 is deposited, and after the bottom of the substrate 101 is lapped, an Au-Ge/Au electrode 110 is deposited thereon. Finally, ohmic contacts of the electrodes 109 and 110 are achieved by a high-temperature treatment, and a wafer is chipped.

In the above structure, NRZ signals of 150 Mbps are input into the respective semiconductor lasers 118, and the wavelength division multiplexed signals are emitted from a common emission end. It is confirmed that respective light signals can be independently transmittable, by demultiplexing and detecting the thus emitted light signals.

The oscillation wavelengths $\lambda_i$, fine grating pitches $\Lambda_{LD,i}$ of the DFB type lasers 118 and grating pitches $\Lambda_{g,i}$ of the grating directional couplers 119 at respective stages are as follows:

|  | $\lambda_i$(nm) | $\Lambda_{LD,i}$(nm) | $\Lambda_{g,i}$(nm) |
|---|---|---|---|
| 1) | 830 | 237 | 9.1 |
| 2) | 835 | 239 | 9.3 |
| 3) | 840 | 240 | 9.5 |
| 4) | 845 | 241 | 9.7 |
| 5) | 850 | 243 | 9.9 |

The depth of each grating directional coupler 119 is 0.1 μm, the grating region length is 400 μm, the depth of the fine grating 115 in each semiconductor laser 118 is 0.1 μm and its region length is 300μm. Thus, a multi-wavelength light emitting apparatus consisting of five units has an entire length of 3.5 mm, and its width which corresponds to the electrode width is only about 100μm.

In the first example, the DFB type semiconductor laser is used, and the grating directional coupler utilizes a forward coupling. In a fourth embodiment explained below, a DBR type laser and a reverse coupling are used. Its fabrication process is substantially the same as that of the third embodiment.

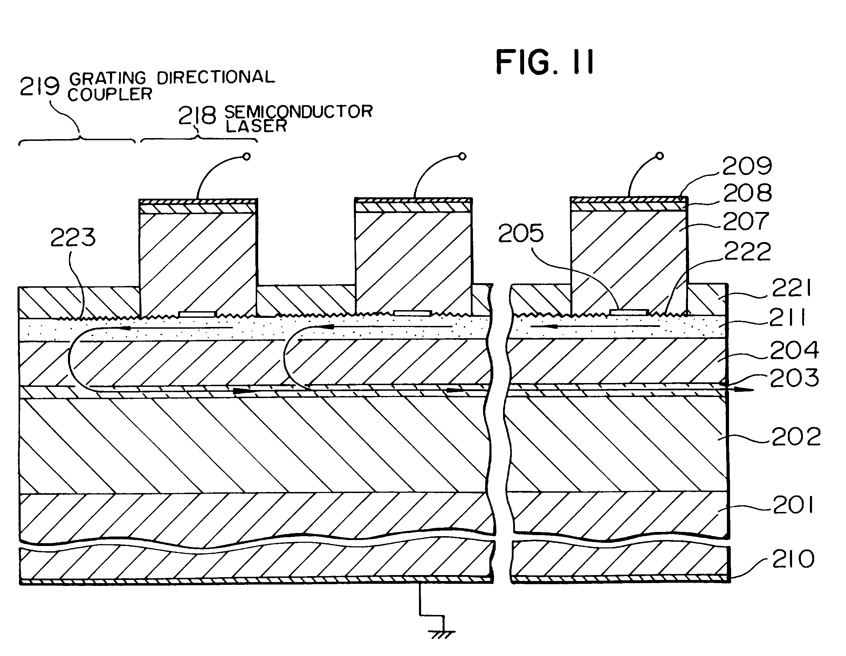

In a DBR type laser 218, as shown in Fig 11, an active layer 205 is formed only in an active region interposed between gratings (DBR) 222. In a grating directional coupler 219, a cladding layer 221 of $Si_3N_4$ is formed on a grating 223. The grating 223 in the grating directional coupler 219 has a finer pitch than that of the third embodiment, and its pitch is determined by the following equation (3) instead of the equation (2).

$$\Lambda_{g,i} = M \cdot \lambda_i / |n_{up,i} + n_{com,i}| \quad (M=1, 2, 3, ...) \qquad (3)$$

In the reverse coupling (the plus sign (+) at the right side indicates the reverse coupling), the oscillated light of the semiconductor laser 218 propagates through a common waveguide 203 in a reverse direction to the light propagating direction in an upper waveguide 211, when the oscillated light is guided into the common waveguide 203 by the grating directional coupler 219. Lights radiated from the respective semiconductor lasers 218 are guided to the common waveguide 203 by the respective grating couplers 219 and propagated through the common waveguide 203. Those propagating lights will not be coupled to downstream semiconductor lasers 218 and grating directional couplers 219 when propagating therethrough. Thus, those lights are emitted from a common emission end (in Fig. 11, the end surface at the right-hand side.). In the reverse coupling, the wavelength selectivity is sharper than that in the forward coupling, and therefore, intervals between radiated wavelengths of the semiconductor lasers 218 can be shortened. As a result, the wavelength multiplicity of the wavelength division multiplexing system can be increased.

When the grating 223 of the grating directional coupler 219 is fabricated in the second embodiment, a photomask cannot be used as in the third embodiment since its pitch is fine. Therefore, the grating 223 is formed by using a two-beam interference pattern of a He-Cd laser and then performing the exposure as in the case of the DBR type laser 218. Also in the fourth embodiment, NRZ signals of 150 Mbps are input into the respective semiconductor lasers 218, and the wavelength division multiplexed signals are emitted from a common emission end (its multiplicity is ten). In this case, there are provided ten units of DBR type lasers 218 and grating directional couplers 219.

The length of the grating directional coupler 219 is 200 μm, and the length of the DBR type laser 218 is 400 μm. Therefore, a multi-wavelength light emitting apparatus consisting of ten units has an entire length of 6 mm. In Fig. 11, elements or portions having the same function as those in Fig. 10 are designated by corresponding numerals in two hundred.

In the second example useful for the understanding of the invention, the semiconductor laser 218 may be constructed as a tunable one in which its oscillation wavelength is changeable. In this case, the range of changeable wavelengths is relatively narrow, and hence the grating 223 in the grating directional coupler 219 can be used as it is. With respect to a tunable laser, see, for example, "Distributed Bragg Reflection Type LD (DBR LD) Having Phase Regulating Region And Bragg Wavelength Control Region" written in Electronics Letters, vol. 23, No. 3, pp. 403~405 (1987) and "Multi-Electrode Distributed Feedback LD (DFB LD)" written in the same journal, vol. 25. No. 15, pp. 990~992 (1989).

In the multi-wavelength light emitting apparatus of the examples a plurality of units of semiconductor lasers arid grating directional couplers having gratings of different pitches are serially arranged In the light propagating direction in accordance with the wavelength multiplicity. As a result, for example, wavelength division multiplexed light signals can be independently driven, and these signals can be transmitted from a common emission end.

The grating directional coupler for coupling the light radiated from the semiconductor laser to the common waveguide is serially connected directly to the corresponding semiconductor laser, and its coupling length is short. Therefore, the entire length of the multi-wavelength light emitting apparatus can he reduced and made compact in size, compared to a conventional case where an ordinary coupler is used. Thus, the device of the present invention is suitable to the integration Furthermore, since the grating directional coupler has a sharp wavelength selectivity near the Bragg condition, the interval between radiated wavelengths from the semiconductor lasers can be shortened. As a result, the wavelength multiplicity of the wavelength division multiplexing system can be increased, and the number of signal channels can be set to a large number.

While in the embodiments solely photodetectors and in the examples semiconductor lasers are provided together with grating directional couplers , at least one photodetector and at least one semiconductor laser may be formed, according to the invention, together with grating directional couplers for selectively or simultaneously, performing light detecting and light emitting functions. The fabrication method therefor may be conducted by combining the above-mentioned fabricating processes.

While the present invention has been described with respect to what is presently considered to be the preferred embodiments, it is understoof that the invention is not limited to the disclosed embodiments. The present invention is intended to cover various modifications; and equivalent, arrangements included within the scope of the appended claims.

**Claims**

1. A multi-wavelength light detecting apparatus comprising a plurality of serially arranged first units (**70, 71, 94, 95**) each containing a first directional coupler (**70, 95**) having a grating (**60; 97**) for a wavelength demultiplexing function and a photodetector (**71, 94**) having a photoelectric conversion function, said first directional coupler (**70, 95**) and said photodetector (**71, 94**) being serially arranged in a light propagating direction, said first directional coupler (**70, 95**) of each first unit having two parallel light waveguides (**64, 66, 84, 86**) one of said parallel waveguides being a common light waveguide (**64, 84**) through which light is input and propagated and from which light is coupled out to the corresponding first unit photodetector via the other of the two light waveguides, and which gratings of said first units have different pitches,
**characterized in that**

said plurality of first units (**70, 71, 94, 95**) are arranged in an order from the shortest pitch of said grating (**60, 97**) thereof to a longest pitch of said grating thereof from a light input side; a groove is mounted between adjacent first units (**70, 71, 94, 95**) for preventing light demultiplexed from said common light waveguide (**64, 84**) by the first directional coupler of a first unit from invading the photodetector of an adjacent first unit, or an absorbing region (**79**) is mounted between adjacent first units (**70, 71, 94, 95**) for preventing light demultiplexed from said common light waveguide (**64, 84**) by the first directional coupler of a first unit from invading a photodetector of an adjacent first unit, or a boundary surface between adjacent first units is slantly formed to the light propagation direction for preventing light demultiplexed from said common light waveguide (**64, 84**) by the first directional coupler of a first unit from invading the photodetector of an adjacent first unit.

2. A multi-wavelength light detecting apparatus according to claim 1, **characterized in that** said first directional coupler (**70; 95**) comprises a cladding layer (**65; 85**) between said two parallel waveguides (**64, 66; 84, 86**) formed on a substrate (**63; 83**).

3. A multi-wavelength light detecting apparatus according to claim 1 or 2, **characterized in that** said grating (**60; 97**) is formed on one of said two parallel waveguides (**64, 66; 84, 86**).

4. A multi-wavelength light detecting apparatus according to any of the preceding claims, **characterized in that** said photodetector (**71; 94**) comprises a MES-FET type photodetector.

5. A multi-wavelength light detecting apparatus according to any of the preceding claims, **characterized in that** said photodetector (**71; 94**) comprises a pin photodetector.

6. A multi-wavelength light detecting apparatus according to any of the preceding claims, **characterized by** means (**78**) for changing an effective pitch of said grating (**60; 97**).

7. A multi-wavelength light detecting apparatus according to any of the preceding claims, **characterized by** at least a second unit (**118, 119**) of a second directional coupler (**119**) having a grating (**114**) for an optical coupling function and a semiconductor laser (**118**), wherein said second directional coupler (**119**) and said semiconductor laser (**118**) are serially arranged in the light propagating direction and parallel with said common light waveguide (**103**) such that light of the semiconductor laser of each second unit can be coupled by means of the corresponding grating into the common waveguide.

8. A multi-wavelength light detecting apparatus according to claim 7, **characterized by** a plurality of said second units (**118, 119**), wherein said gratings (**114**) of said second directional couplers (**119**) have different pitches from each other.

**Patentansprüche**

1. Lichtdetektor-Vorrichtung für mehrere Wellenlängen, umfassend eine Vielzahl von seriell angeordneten ersten Einheiten (70, 71, 94, 95), von denen jede einen ersten Richtkoppler (70, 95) mit einem Gitter (60, 97) für eine Wellenlängen-Demultiplexfunktion und einen Photodetektor (71, 94) mit einer photoelektrischen Umwandlungsfunktion enthält, wobei der erste Richtkoppler (70, 95) und der Photodetektor (71, 94) in einer Lichtfortbewegungsrichtung seriell angeordnet sind, der erste Richtkoppler (70, 95) von jeder ersten Einheit zwei parallele Lichtwellenleiter (64, 66, 84, 85) umfaßt, wobei einer von den parallelen Wellenleitern ein gemeinsamer Lichtwellenleiter (64, 68) ist, durch den Licht eingegeben wird und sich fortbewegt und von dem Licht zu dem entsprechenden Photodetektor der ersten Einheit über den anderen der zwei Wellenleiter ausgekoppelt wird und wobei die Gitter der ersten Einheiten verschiedene Gitterkonstanten haben, **dadurch gekennzeichnet, daß**

die Vielzahl von ersten Einheiten (70, 71, 94, 95) in einer Reihenfolge von der kürzesten Gitterkonstante des Gitters (60, 97) zu der längsten Gitterkonstante des Gitters (60, 97) von der Lichteingangsseite angeordnet sind;
eine Einkerbung zwischen angrenzenden ersten Einheiten (70, 71, 94, 95) angebracht ist, um zu verhindern, daß von dem gemeinsamen Lichtwellenleiter (64, 84) durch den ersten Richtkoppler einer ersten Einheit demultiplextes Licht in den Photodetektor einer angrenzenden ersten Einheit eindringt, oder ein Absorptionsbereich (79) zwischen angrenzenden ersten Einheiten (70, 71, 94, 95) angebracht ist, um zu verhindern, daß von dem gemeinsamen Lichtwellenleiter (64, 84) durch den ersten Richtkoppler einer ersten Einheit demultiplextes Licht in den Photodetektor einer angrenzenden ersten Einheit eindringt, oder eine Grenz-Oberfläche zwischen angrenzenden ersten Einheiten schräg zu der Lichtfortbewegungsrichtung gebildet ist, um zu verhindern, daß von dem gemeinsamen Lichtwellenleiter (64, 84) durch den ersten Richtkoppler einer ersten Einheit demultiplextes Licht in den Photodetektor einer angrenzenden ersten Einheit eindringt.

2. Lichtdetektor-Vorrichtung für mehrere Wellenlängen nach Anspruch 1, **dadurch gekennzeichnet, daß**
der erste Richtkoppler (70; 95) eine Mantelschicht (65; 85) zwischen den zwei auf einem Substrat (63; 83) gebildeten parallelen Wellenleitern (64, 66; 84, 86) umfaßt.

3. Lichtdetektor-Vorrichtung für mehrere Wellenlängen nach Anspruch 1 oder 2, **dadurch gekennzeichnet, daß**
das Gitter (60; 97) auf einem der zwei parallelen Wellenleitern (64, 66; 84, 86) gebildet ist.

4. Lichtdetektor-Vorrichtung für mehrere Wellenlängen nach einem der vorhergehenden Ansprüche, **dadurch gekennzeichnet, daß**
der Photodetektor (71; 94) einen Photodetektor vom MES-FET-Typ umfaßt.

5. Lichtdetektor-Vorrichtung für mehrere Wellenlängen nach einem der vorhergehenden Ansprüche, **dadurch gekennzeichnet, daß**
der Photodetektor (71; 94) einen pin-Photodetektor umfaßt.

6. Lichtdetektor-Vorrichtung für mehrere Wellenlängen nach einem der vorhergehenden Ansprüche, **gekennzeichnet durch**
Einrichtungen (78), um eine effektive Gitterkonstante des Gitters (60; 97) zu verändern.

7. Lichtdetektor-Vorrichtung für mehrere Wellenlängen nach einem der vorhergehenden Ansprüche, **gekennzeichnet durch**
mindestens eine zweite Einheit (118, 119) aus einem zweiten Richtkoppler (119) mit einem Gitter (114) für eine optische Kopplungsfunktion und einem Halbleiterlaser (118), wobei der zweite Richtkoppler (119) und der Halbleiterlaser (118) seriell in der Lichtfortbewegungsrichtung und parallel zu dem gemeinsamen Lichtwellenleiter (103) angeordnet sind, so daß Licht von dem Halbleiterlaser von jeder zweiten Einheit durch das entsprechende Gitter in den gemeinsamen Wellenleiter gekoppelt werden kann.

8. Lichtdetektor-Vorrichtung für mehrere Wellenlängen nach Anspruch 7, **gekennzeichnet durch** eine Vielzahl von zweiten Einheiten (118, 119), wobei die Gitter (114) der zweiten Richtkoppler (119) voneinander verschiedene Gitterkonstanten haben.

## Revendications

1. Dispositif détecteur de lumières de plusieurs longueurs d'onde comprenant une pluralité de premiers modules agencés en série (70, 71, 94, 95) contenant chacun un premier coupleur directif (70, 95) comportant un réseau (60 ; 97) pour une fonction de démultiplexage de longueur d'onde et un photodétecteur (71, 94) ayant une fonction de conversion photoélectrique, ledit premier coupleur directif (70, 95) et ledit photodétecteur (71, 94) étant agencés en série dans une direction de propagation de lumière, ledit premier coupleur directif (70, 95) de chaque premier module comportant deux guides d'onde de lumière parallèles (64, 66, 84, 86), l'un desdits guides d'onde parallèles étant un guide d'onde de lumière commun (64, 84) par lequel la lumière entre et se propage et duquel la lumière est délivrée en sortie au photodétecteur de premier module correspondant, par l'intermédiaire de l'autre des deux guides d'onde de lumière, les réseaux desdits premiers modules ayant des pas différents ; caractérisé :

en ce que ladite pluralité de premiers modules (70, 71, 94, 95) est agencée dans un ordre allant du pas le plus court de son dit réseau (60, 97) au pas le plus long de son dit réseau, à partir d'un côté d'entrée de lumière ; en ce qu'une rainure est placée entre des premiers modules (70, 71, 94, 95) adjacents pour empêcher la lumière démultiplexée par le premier coupleur directif d'un premier module et issue dudit guide d'onde de lumière commun (64, 84) de pénétrer dans le photodétecteur d'un premier module adjacent, ou en ce qu'une région d'absorption (79) est placée entre des premiers modules (70, 71, 94, 95) adjacents pour empêcher la lumière démultiplexée par le premier coupleur directif d'un premier module et issue dudit guide d'onde de lumière commun (64, 84) de pénétrer dans un photodétecteur d'un premier module adjacent, ou en ce qu'une surface frontière entre des premiers modules adjacents est formée en biais par rapport à la direction de propagation de lumière pour empêcher la lumière démultiplexée par le premier coupleur directif d'un premier module et issue dudit guide d'onde de lumière commun (64, 84) de pénétrer dans le photodétecteur d'un premier module adjacent.

2. Dispositif détecteur de lumières de plusieurs longueurs d'onde selon la revendication 1, caractérisé en ce que ledit premier coupleur directif (70 ; 95) comprend une couche plaquée (65 ; 85) entre lesdits deux guides d'onde parallèles (64, 66 ; 84, 86) formés sur un substrat (63 ; 83).

3. Dispositif détecteur de lumières de plusieurs longueurs d'onde selon la revendication 1 ou 2, caractérisé en ce que ledit réseau (60 ; 97) est formé sur l'un desdits deux guides d'onde parallèles (64, 66 ; 84, 86).

4. Dispositif détecteur de lumières de plusieurs longueurs d'onde selon l'une quelconque des revendications précédentes, caractérisé en ce que ledit photodétecteur (71 ; 94) comprend un photodétecteur de type MESFET (transistor à effet de champ à accès Schottky).

5. Dispositif détecteur de lumières de plusieurs longueurs d'onde selon l'une quelconque des revendications précédentes, caractérisé en ce que ledit photodétecteur (71 ; 94) comprend un photodétecteur PIN.

6. Dispositif détecteur de lumières de plusieurs longueurs d'onde selon l'une quelconque des revendications précédentes, caractérisé par un moyen (78) pour modifier le pas réel dudit réseau (60 ; 97).

7. Dispositif détecteur de lumières de plusieurs longueurs d'onde selon l'une quelconque des revendications précédentes, caractérisé par au moins un second module (118, 119) d'un second coupleur directif (119) comportant un réseau (114) pour une fonction de couplage optique, et un laser à semiconducteur (118), dans lequel ledit second coupleur directif (119) et ledit laser à semi-conducteur (118) sont agencés en série dans la direction de propagation de lumière et parallèles audit guide d'onde de lumière commun (103) de façon telle que la lumière du laser à semi-conducteur de chaque second module puisse être délivrée, au moyen du réseau correspondant, dans le guide d'onde commun.

8. Dispositif détecteur de lumières de plusieurs longueurs d'onde selon la revendication 7, caractérisé par une pluralité desdits seconds modules (118, 119), dans lequel lesdits réseaux (114) desdits seconds coupleurs directifs (119) ont des pas différents les uns des autres.

# FIG. 1
# PRIOR ART

# FIG. 2
# PRIOR ART

# FIG. 3
## PRIOR ART

# FIG. 4
## PRIOR ART

# FIG. 5
## PRIOR ART

# FIG. 6

INPUT LIGHT SIGNALS

$\lambda_1 \sim \lambda_5$

70 DEMULTIPLEXING REGION

71 LIGHT DETECTING REGION

78

79

$\lambda_1$  $\lambda_2$  $\lambda_3$  $\lambda_4$  60  $\lambda_5$  68 75

67
66
65
64
63
62
61

EP 0 496 348 B1

# FIG. 7

# FIG. 8

FIG. 9

# FIG. 10

118 SEMICONDUCTOR LASER

λ/4 SHIFT

119 GRATING DIRECTIONAL COUPLER

113
115
112
111
114

109
108
107
106
105
104
103
102
101
110

EP 0 496 348 B1

# FIG. II

219 GRATING DIRECTIONAL COUPLER

218 SEMICONDUCTOR LASER

223

205

209
208
207
222
221
211
204
203
202
201
210